# EUROPEAN PATENT APPLICATION

(11) **EP 4 766 039 A1**
(43) Date of publication of application: **24.06.2026**
(21) Application number: 24220704.1
(22) Date of filing: 17.12.2024
(51) Int. Cl.: H05K 5/00

(54) **ELECTRONIC CONTROL UNIT AND METHOD FOR MOUNTING THE ELECTRONIC CONTROL UNIT**

(71) Applicant: ZF CV Systems Global GmbH, 3006 Bern (CH)
(72) Inventor: SLOWINSKI, Tomasz, 54-607 Wroclaw (PL); SZCZERBA, Dominik, 55-040 Domaslaw (PL); WOLANSKI, Michal, 54-129 Wroclaw (PL)
(74) Representative: Schäferjohann, Volker

(57) **Abstract**

The invention relates to an electronic control unit (1) for controlling application circuits, said electronic control unit (1) comprising:
a housing (2) with a front opening,
a printed circuit board (3) with electronic components (5),
at least one connector (4; 4a, 4b, 4c, 4d, 4e) being mounted on a front end (3a) of said printed circuit board (3) and extending in a longitudinal direction (X),
a frame comprising a lower frame part (6) and an upper frame part (8), wherein said lower frame part (6) and said upper frame part (8) being fixed to each other thereby holding or clamping said connectors (4) therebetween,
wherein at least one of said frame parts (6, 8) comprises at least two spacers (18) protruding in a vertical direction (Z) between two adjacent connectors (4) of said connectors (4), thereby holding or clamping said at least one connector (4),
wherein said printed circuit board (3) with said frame (6, 8) is inserted into said front opening of said housing (2) in said longitudinal direction (X),
wherein said frame (6, 8) is fixed to said housing (2).

## Description

The invention relates to an electronic control unit, which is in particular adapted for automotive applications, and to a method for mounting the electronic control unit.

Electronic control units (ECUs) used in automotive applications typically comprise a printed circuit board with electronic components and a housing that surrounds and protects the printed circuit board (PCB) and the electronic components. In addition, various connectors are mounted on the PCB and extend through a front opening in the housing for contacting the ECU. These ECUs often have electronic connectors only on their front side to facilitate the assembly of the ECU on a vehicle structure, in particular via fixation lugs or fixing tabs of the housing.

The ECUs typically comprise a variety of different connectors required for specific applications and vehicle models. The connectors can be multipoint or single point connectors, often using customized main housing parts to receive the specific connectors. However, these specific configurations, in particular a large number of different housings and multi point connectors with specific fixing or mounting means, result in high costs and time to create the configurations. Multipoint connectors can be used to combine several connectors or connector types, with the multipoint connector being mounted as a single part on the PCB. Alternatively, individual single connectors can be mounted on the PCB.

It is therefore an object of the invention to provide an electronic control unit and a method of mounting the electronic control unit which allows easy assembly and low cost without limiting the variety of connectors for use in the electronic control unit.

This object is solved by the electronic control unit according to the independent claims, further a method of mounting the electronic control unit is provided. The subclaims describe preferred embodiments.

Thus, the inventive electronic control unit (ECU) comprises a printed circuit board (PCB) with at least one connector, mounted on a front end of the PCB, which are fixed by a frame which secures the connectors, wherein said frame is further used for fixing the PCB with the connectors in the housing. The frame therefore comprises a lower frame part and an upper frame part, which are vertically fixed to each other thereby housing or receiving the connectors between them.

This inventive solution allows fast and secure assembly without limiting the number and type of connectors. The connectors can be mounted on the front end of the PCB independently, with a space or distance between them, or with a lateral contact between them, but without the need for specific connector fixing means. The fixation of the connectors is then realised by pushing the frame parts in a vertical direction onto each other, whereby the connectors are fixed or clamped between them, in particular separately. At least one of the frame parts comprises at least one spacer which extends or protrudes between two adjacent connectors, thereby fixing the connectors in the transverse direction and increasing the stability.

According to a preferred embodiment, at least one connector is fixed between two of the spacers; preferably, all connectors are fixed between two spacers, respectively. According to a preferred embodiment, at least two adjacent connectors are separated from each other by one of said spacers
Thus, the spacers separate and fix the connectors, in particular without any further fixing means, thereby providing a safe solution with relatively little effort.

Preferably, two adjacent spacers of the two frame parts are in contact with each other, thereby realising a clamping or stabilising contact between the frame parts and a clamping or recess for the connectors.

According to a preferred embodiment, at least two of said connectors differ in at least one of the following characteristics: heigt, width, number of pins, shape.Thus, a high variety of connectors can be used. In addition, a poka-yoke system can be realized, since two almost identical connector with only one or a few changes inside - position of rib for example, can be distinguished.

The invention thus offers the possibility of multiple single connector configurations. A preferred feature of the invention is a system of internal fixation frames that surround single connectors of the PCB and provide a snap-in interface for a housing, in particular a standard main housing. Modularity of the frames allows to use different connector configurations within same housing, and there is no longer need to build specific multipoint connector or customized main housing for new applications.

The frame parts preferably combine several functions: Firstly, the frame parts are used to clamp and fix the connectors independently of each other. Secondly, the frame parts protect the connectors in the vertical and lateral directions. Thirdly, the frame parts form a closed frame which can then be inserted into the housing and fixed in the housing, in particular by means of a secure locking mechanism, in particular a snap fit.

Thus, a simple and reliable assembly is possible; according to a preferred embodiment, the two frame parts are pushed in vertical directions onto the connectors, thereby fixing and separating the connectors and locking them together, in particular by a snap fit. The closed frame then houses and covers the connectors. The PCB with the mounted frame is then inserted into the front opening of the housing and fixed in the housing by the frame parts, in particular by snap-fitting. This assembly method is safe and easy to perform.

According to a preferred embodiment, the lower frame part and the upper frame part are fixed to each other by snap fits, in particular snap fits on a rear face since such a snap fit does not protrude on the side faces or other faces when the frame is inserted into the housing. The contact between the spacers already provides a high level of stability; the snap fit between the frame parts enhances and improves this stability. In addition, the fixing of the frame parts inside the housing, in particular the snap fit, further increases the stability of the frame and the mounted connectors.

According to a preferred embodiment, the frame formed by the frame parts is an internal frame which is completely pushed into the housing, which is preferably a standard housing, so that the ECU can be mounted with its standard housing in common applications.

According to a preferred embodiment, the connectors are completely covered not only by the frame parts, but in particular by the housing. Thus, according to a preferred embodiment, the connectors do not protrude from the housing. This protects the connectors from accidental damage. The connectors can then be contacted from the front in the usual way.

The housing and frame parts are preferably made of plastic material, which provides a soft and improved snap fit.

According to a further embodiment, at least one fastening or fixing is realized or improved by additional fastening means like screws or bolts. The use of those additional fastening means can improve the sustainability by improving this assembly without specific tools.

The invention is hereinafter described in more detail with reference to the appended drawings, in which:
- Fig. 1: is a perspective front view of an electronic control unit according to an embodiment of the invention, in its assembled state;
- Fig. 2: shows the ECU of fig. 1 in its disassembled state;
- Fig. 3: is a front view of the ECU, in disassembled state;
- Fig. 4: is a perspective rear view of the PCB with connectors and frames, in disassembled state;
- Fig. 5: shows the ECU from fig. 4 after snap fit of the frames;
- Fig. 6: shows the ECU after assembly of the frame, before pushing the PCB into the housing;
- Fig. 7: is a perspective front view of an embodiment with connectors covered by the housing.

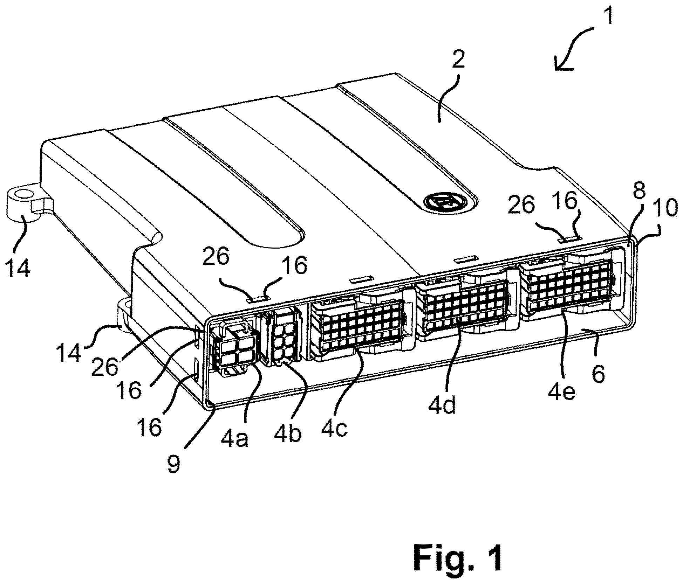

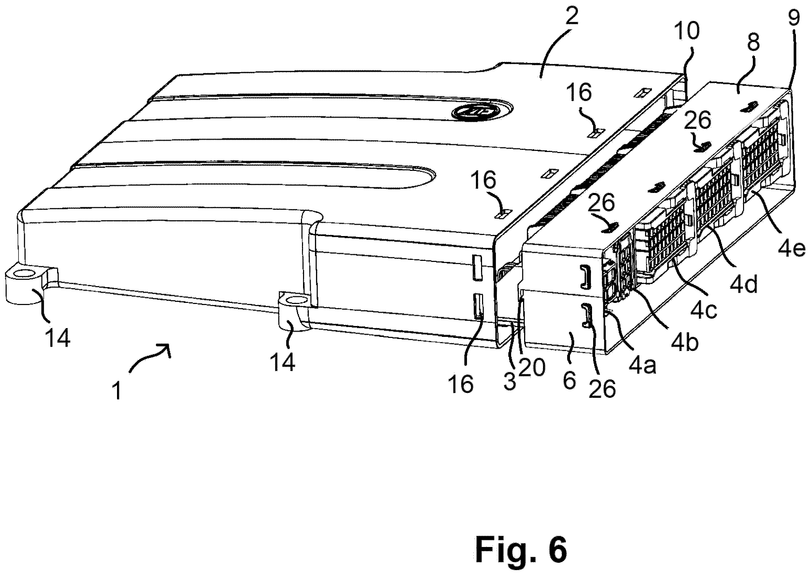

Fig. 1 to 8 show an electronic control unit 1, hereinafter ECU 1, comprising a housing 2, preferably made of plastic material, a printed circuit board 3, hereinafter PCB 3, at least one connector 4, for example five connectors 4, a lower frame part 6 and an upper frame part 8. The housing 2 is preferably closed with only a front opening 10 providing access to its internal space 11, in which sliding guides 12 are provided for receiving the PCB 3. The housing preferably has fastening lugs 14 for mounting it on a vehicle structure, for example. The housing 2 further comprises snap fit recesses 16, preferably as snap-in recesses, at its front end, preferably surrounding the front opening 11, in particular on a bottom face, a top face and side faces of the housing 2.

The Carthesian coordinates X, Y, Z refer to a longitudinal direction X, a transverse direction Y and a vertical direction Z. The longitudinal direction X corresponds to the insertion direction for inserting the PCB 3 into the housing 2. In this content, both X and the reverse direction -X refer to as the longitudinal direction; Z and -Z refer to as the vertical direction, and Y and -Y refer to as the transverse direction.

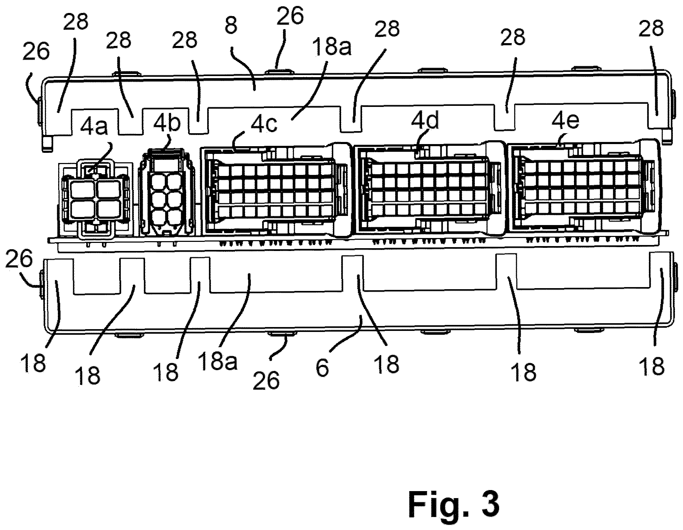

The PCB 3 can be of usual type comprising printed circuits and electronic components 5. The connectors 4 are mounted on a front end 3a of the PCB 3. The connectors 4 can be of different types, different shapes and different numbers of pins or contacts. The connectors 4 can comprise multi-connector parts as well as single connectors, as shown in the embodiment. The connectors 4 are mounted on the PCB 3 and contacted with it. The connectors 4 can be separated from each other with no direct contact between them, as can be seen, for example, from the front view of fig. 3.

The frame parts 6 and 8 fulfil different functions - they are mounted vertically to the front end 3a of the PCB 3, clamping the connectors 4 between them, contacting each other with a form fit, in particular a snap fit, and serving as mounting means for fixing in the housing 2, as described hereinafter.

The frame parts 6 and 8 are made of plastic material, e.g. the same plastic material as the housing 2, and are provided with a plurality of recesses and spacers, as explained below. At least one of the frame parts 6, 8, preferably both frame parts 6, 8 have spacers 18, 28 projecting vertically, in particular symmetrically to each other and/or opposing each other, with the same or different length in the vertical direction. In the shown embodiment, the lower frame part 6 has lower spacers 18 projecting upwards and the upper frame part 8 has upper spacers 28 projecting downwards. The lower and upper spacers 18, 28 preferably contact each other and define between them spaces 18a for receiving connectors 4. In the embodiment shown, five connectors 4 of different widths and heights are mounted on the front end 3a of the PCB 3. The connectors 4 can be mounted independently of each other and they can be attached to each other on the side faces, as can be seen from Fig. 3, in which the three larger connectors 4 on the right side can abut each other; however, the connectors 4 can also be mounted with spaces between them, as can be seen from the left part of Fig. 3, with two smaller connectors 4.

The spacers 18, 28 are pushed or shifted into recesses or spaces between or in the connectors 4, thereby fixing, separating and clamping the connectors 4 between the frames 6 and 8. Furthermore, the two frame parts 6, 8 comprise fixing means 20 for fixing them to each other; in the embodiment shown, the fixing means 20 are realised by a snap fit, for example with an elastic hook 20a on the upper frame part 8 and a recess 20b for receiving the hook 20a on the lower frame part 6, or vice versa

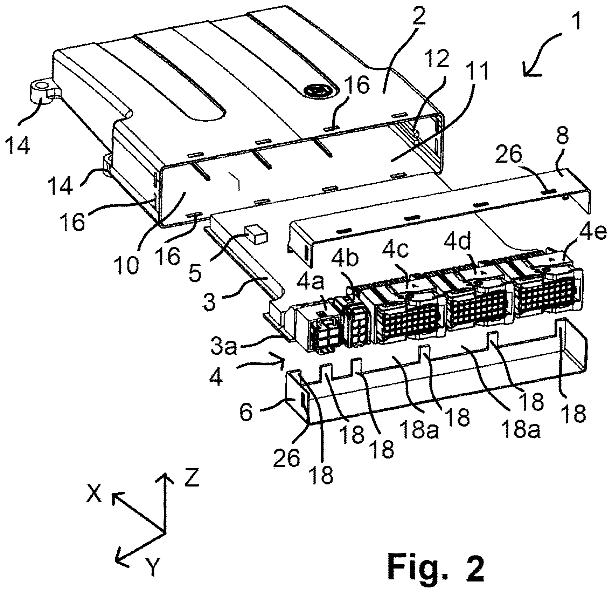

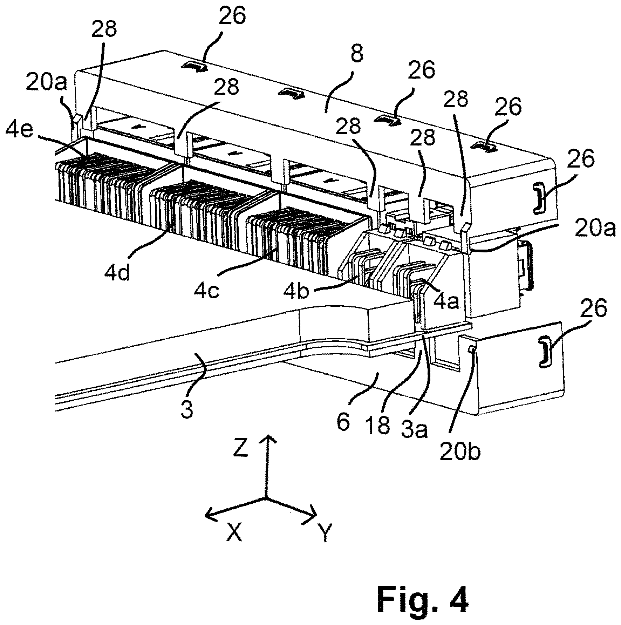

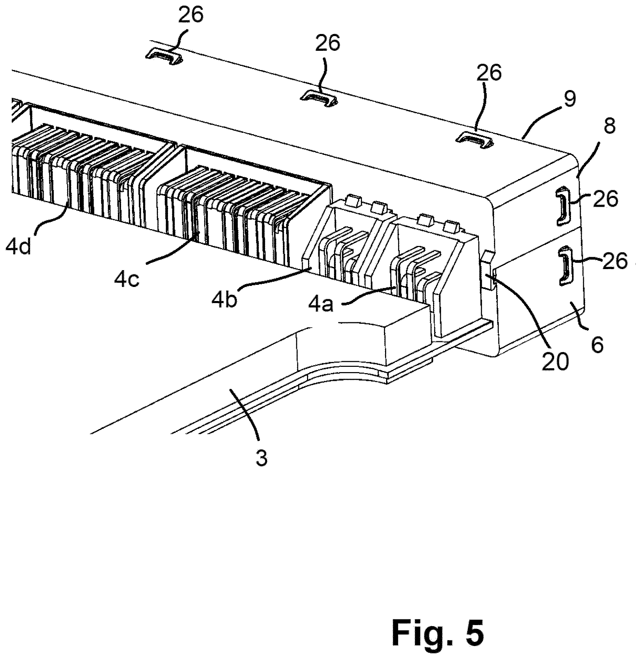

In the first assembly step, starting from the disassembled arrangement of figures 2 and 4, the frame parts 6, 8 are pushed or shifted vertically onto the PCB 3, with the spacers 18, 28 being inserted between the connectors 8, thereby clamping and positively locking them. No further fixing of the connectors 4 is therefore necessary. Furthermore, the snap-fit parts 20a, 20b snap into each other and form the snap-fit 20 of Fig. 5, thereby forming a closed frame 9 with the connectors 4 between them. This arrangement of the printed circuit board 3 with the closed frame 9 is then inserted into the front opening 10, the printed circuit board 3 sliding on the sliding guides 12. The closed frame 9 fits into the front opening 11 and the housing 2 and snap-fits into the housing 2, for this purpose, a further snap fit arrangement is provided on the frame parts 6, 8 and the housing 2; the snap fit recesses 16 distributed on the housing 2 near the front end 10 receive corresponding snap fit protrusions 26 provided on the frame parts 6, 8, thereby enabling a self-locking snap fit. The snap fit protrusion 26 are preferably provided on both frame parts 6, 8, in order to increase the stability. As can be seen from Fig. 2, the recesses 16 and the snap fit protrusions 26 can be distributed on the bottom faces, top faces and side faces of the housing 2 and the frame 9, respectively.

Thus, a quick and secure assembly of the ECU 1 is possible, wherein the frame parts 6, 8 are first pushed onto the front end 3, thereby receiving the connectors 4 between them, and are snap-fitted to one other, thereby forming the closed frame 9. Then the PCB 3 with the frame 9 is shifted or pushed into the front opening 10 until the frame parts 6, 8 snap-fit with their snap-fit protrusion 26 in the recesses 16 of the housing 2. Therefore, no further tools for assembling the ECU 2 are necessary, as can be seen from the figures. However, an additional fixing by means of screws is not necessary but is possible. According to a further embodiment, the snap fit by the snap fit protrusions 26 and recesses 16 can be replaced by a screw fixation, for example with screws inserted in longitudinal direction X and fixing the frame parts 6, 8 to the housing 2. In such an alternative embodiment, the housing 2 can be provided with suitable fastening lugs or fastening surfaces for receiving the screws. Furthermore, screws can be inserted in the vertical direction Z, -Z

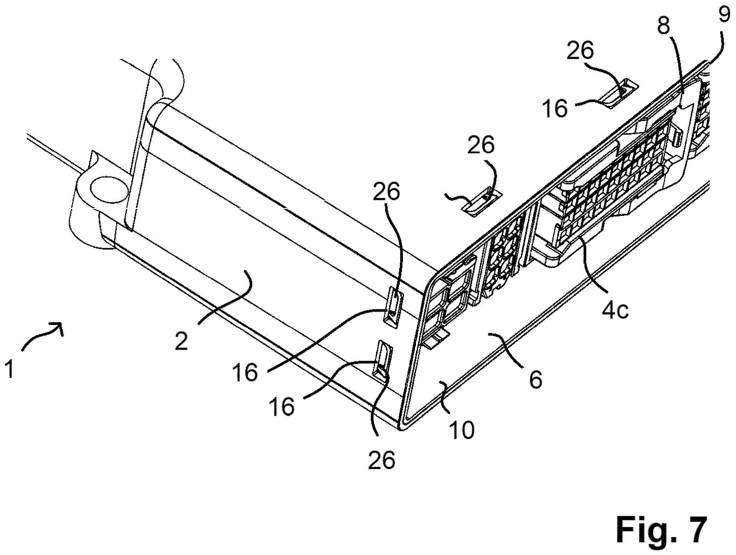

The frame 9 can be pushed completely into the housing 2, as can be seen from the perspective front views of figures 1 and 7. The housing 2 thus serves as a cover and protection for the connectors 4; according to this preferred embodiment, the connectors 4 do not protrude from the housing 2.

The assembled ECU 1 can be disassembled with a specific tool to release the snap fits. In alternative embodiments with screw fixings, the disassembling is simplified, thereby increasing sustainability.

The ECU 1 can be provided for various applications, in particular automotive applications, for example an ABS controller, a suspension controller, e.g. an ECAS suspension controller, a steering controller, an air condition management controller, or a light controller. The snap fit connection can be improved to ensure a watertight design. Several electronic components 5, in particular integrated circuits such as electronic control circuits, can be mounted on the PCB 3, for the relevant functions.

In the embodiment shown, five connectors 4a, 4b, 4c, 4d and 4e are provided, which can have different widths in transverse direction Y, different heights in vertical direction Z and different numbers of pins or contacts.

### List of reference numerals (part of the description)

- 1: electronic control unit
- 2: housing
- 3: PCB (printed circuit board)
- 3a: front end of the PCB 3
- 4, 4a, 4b, 4c, 4d, 4e: connectors
- 5: electronic components
- 6: lower frame part
- 8: upper frame part
- 9: frame
- 10: front opening
- 11: internal space
- 12: sliding guides
- 14: fastening lugs
- 16: snap-fit recesses
- 18: lower spacers
- 18a: spaces between the spacers 18
- 20: fixing means
- 20a: hook
- 20b: recess
- 26: snap-fit protrusions
- 28: upper spacers
- X, Y, Z: Carthesian coordinates
- X: longitudinal direction
- Y: transversal direction
- Z, -Z: vertical direction

## Claims

1. An electronic control unit (1) for controlling application circuits, said electronic control unit (1) comprising:
a housing (2) with a front opening (10),
a printed circuit board (3) with electronic components (5),
at least one connector (4; 4a, 4b, 4c, ed, 4e) being mounted on a front end (3a) of said printed circuit board (3) and extending in a longitudinal direction (X),
a frame (9) comprising a lower frame part (6) and an upper frame part (8), wherein said lower frame part (6) and said upper frame part (8) being fixed to each other thereby holding or clamping said connectors (4) therebetween,
wherein at least one of said frame parts (6, 8) comprises at least two spacers (18, 28) protruding in a vertical direction (z), said at least two spacers (18, 28) holding, clamping or contacting said at least one connector (4) between them,
wherein said printed circuit board (3) with said frame (9) is inserted into said front opening (10) of said housing (2) in said longitudinal direction (X), and
wherein said frame (9) is fixed to said housing (2).

2. The electronic control unit (1) according to claim 1, wherein said at least one connector (4; 4a, 4b, 4c, ed, 4e) is fixed between two of said spacers (18, 28).

3. The electronic control unit (1) according to one of the previous claims, wherein at least two adjacent connectors (4a, 4b; 4c, 4d, 4e) are separated from each other by one of said spacers (18, 28).

4. The electronic control unit (1) according to one of the previous claims, wherein at least two of said connectors (4; 4a, 4b, 4c, 4d, 4e) differ in at least one of the following characteristics:
heigt, width, number of pins, shape.

5. The electronic control unit (1) according to one of the previous claims, wherein said spacers (18) from one of said frame parts (6) contacts the other frame part (8), in particular an opposing spacer (28) of said other frame part (8), thereby defining a contact between said frame parts (6, 8) and defining a space (18a) for receiving one of said connectors (4; 4a, 4b, 4c, 4d, 4e).

6. The electronic control unit (1) according to one of the previous claims, wherein said lower frame part (6) and said upper frame part (8) are fixed to each other by a snap-fit (20), in particular a snap-fit (20) on a rear side, for example a snap fit with a hook (20a) and a recess (20b) for receiving the hook when inserted in said vertical direction.

7. The electronic control unit (1) according to one of the previous claims, wherein said frame (6, 8) is fixed in said housing (2) by a housing snap fit between said frame (9) and said housing (2), said frame (6, 8) being inserted into said housing (2) in longitudinal direction (X) and being locked in said housing (2) from inside, in particular by a snap fit (16, 26).

8. The electronic control unit (1) according to claim 7, wherein said housing snap fit is realized by a plurality of snap fit protrusions (26) and snap fit recesses (16) surrounding said housing (2) and said frame (9).

9. The electronic control unit (1) according to one of the previous claims, wherein said at least one connector (4) is covered by said housing (2) and/or said frame (9) in a vertical direction (Z), said connector (4) being not protruding from said housing (2).

10. Method for assembling an electronic control unit (1) according to one of the previous claims, comprising the steps:
providing a printed circuit board (3) with electronic components (5), a lower frame part (6), an upper frame part (8) and a housing (2) with a front opening (10),
mounting at least one connector (4; 4a, 4b, 4c, 4d, 4e) on a front end (3a) of said printed circuit board (3) and contacting said at least one connector (4) with said printed circuit board (3), said at least one connector (4) protruding from said printed circuit board (3) in a longitudinal direction (X),
mounting said lower frame part (6) and said upper frame part (8) in vertical direction onto each other thereby receiving said at least one connector (4) between them,
wherein said frame parts (6, 8) are fixed to each other and form a frame (9) surrounding or clamping said at least one connector (4),
two spacers (18, 28) of said spacers (18, 28) defining a space (18a) for receiving said connector (4a, 4b),
shifting or pushing said printed circuit board (3) with said mounted frame (9) into said front opening (10) of said housing (2) and fixing said frame (6, 8) in said housing (2).

11. Method according to claim 10, werein at least two connectors (4a, 4b) are provided in adjacent positions, and wherein one spacer (18, 28) of said frame parts extends between said two adjacent connectors (4a, 4b).

12. Method according to claim 10 or 11, wherein said frame parts (8, 9) are fixed to each other by a snap fit locking in particular in the vertical direction (Z).

13. Method according one of claims 10 to 12, wherein the assembly of said frame parts (6, 8) and fixing of said frame (6, 8) in said housing (2) is realized without further tools, in particular by snap-fits for self-locking.
